# EUROPÄISCHE PATENTSCHRIFT

(11) **EP 1 033 809 B1**
(45) Veröffentlichungstag und Bekanntmachung des Hinweises auf die Patenterteilung: **03.06.2009**
(21) Anmeldenummer: 00103843.9
(22) Anmeldetag: 24.02.2000
(51) Int. Cl.: H03F 1/32, H03F 3/45

(54) **Differenzverstärker**
Differential amplifier
Amplificateur différentiel

(30) Priorität: 04.03.1999 DE 19909492
(43) Veröffentlichungstag der Anmeldung: 06.09.2000
(73) Patentinhaber: NXP B.V., 5656 AG Eindhoven (NL)
(72) Erfinder: Burkhard, Dick, Habsburgerallee 11, 52064 Aachen (DE)
(74) Vertreter: van der Veer, Johannis Leendert

(56) Entgegenhaltungen:
- US-A- 4 456 887
- US-A- 5 699 010
- CHUNG W -S ET AL: "BIPOLAR LINEAR TRANSCONDUCTOR" ELECTRONICS LETTERS,GB,IEE STEVENAGE, Bd. 26, Nr. 10, 1. Mai 1990 (1990-05-01), Seiten 619-621, XP000124177 ISSN: 0013-5194

## Beschreibung

Die Erfindung bezieht sich auf einen Differenzverstärker mit wenigstens
- einem ersten Verstärkertransistor, dessen Basisanschluß mit einem Emitteranschluß eines ersten Emitterfolgertransistors gekoppelt ist,
- einem zweiten Verstärkertransistor, dessen Basisanschluß mit einem Emitteranschluß eines zweiten Emitterfolgertransistors gekoppelt ist,
- einer ersten Emitterimpedanz, über die Emitteranschlüsse des ersten und des zweiten Verstärkertransistors miteinander gekoppelt sind,
wobei Basisanschlüssen der Emitterfolgertransistoren zum Steuern des Differenzverstärkers eine Differenzspannung zuführbar ist, gemäß dem Oberbegriff des Anspruchs 1.

In der bipolaren Schaltungstechnik ist es bekannt, zur Linearisierung von Differenzverstärkern eine Emittergegenkopplung einzusetzen. Dabei werden Emitteranschlüsse von einen Differenzverstärker bildenden, bipolaren Transistoren nicht unmittelbar, sondern über wenigstens eine Emitterimpedanz miteinander gekoppelt, die vorzugsweise durch einen ohmschen Widerstand gebildet wird. Je größer dabei der Widerstandswert dieser Emitterimpedanz gegenüber dem Innenwiderstand der Transistoren an ihren Emitteranschlüssen ist, desto linearer wird die Übertragungskennlinie eines derart ausgestalteten Differenzverstärkers. Da jedoch mit zunehmender Aussteuerung der Transistoren des Differenzverstärkers über ihre Basisanschlüsse mit einem Differenzsignal der Strom in jeweils einem der Transistoren des Differenzverstärkers immer mehr abnimmt und sich damit sein Innenwiderstand am Emitteranschluß erhöht, wird für diese großen Aussteuerungen der Linearisierungseffekt der Emitterimpedanz entsprechend geschmälert.

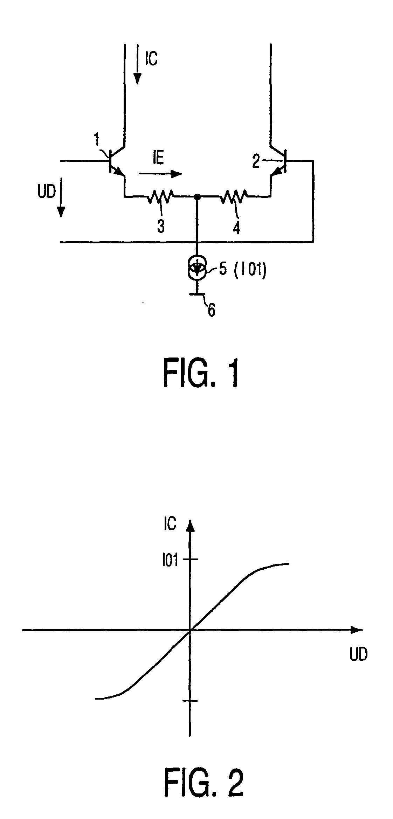

Fig. 1 zeigt eine derartige Anordnung für einen emittergegengekoppelten Differenzverstärker, der einen ersten Verstärkertransistor 1, einen zweiten Verstärkertransistor 2 sowie zwei Emitterwiderstände 3, 4 umfaßt, die in Reihe zueinander geschaltet Emitteranschlüsse der Verstärkertransistoren 1, 2 miteinander verbinden. An die den Emitteranschlüssen abgewandten, miteinander verbundenen Anschlüsse der Emitterwiderstände 3, 4 ist eine Konstantstromquelle 5 angeschlossen, die im gezeigten Schaltbild an Masse 6 führt. Jeder der Emitterwiderstände 3, 4 bildet dabei eine Emitterimpedanz.

Im Betrieb der Schaltungsanordnung nach Fig. 1 wird durch die Konstanstromquelle 5 ein Konstantstrom I01 geführt. Dieser Konstantstrom I02 verteilt sich gemäß der zwischen Basisanschlüssen der Verstärkertransistoren 1, 2 angelegten Differenzspannung DU, die als Eingangsspannung des Differenzverstärkers nach Fig. 1 dient, auf die Kollektor-Emitter-Strecken der beiden Verstärkertransistoren 1, 2. Dabei entspricht eine Zunahme des Stromes in der Kollektor-Emitter-Strecke eines der Verstärkertransistoren 1, 2 unmittelbar einer Abnahme des Stromes in der Kollektor-Emitter-Strecke des anderen der Verstärkertransistoren 1, 2. Für die folgende Betrachtung werden nur die aussteuerungsbedingten Abweichungen der Ströme von ihrem Arbeitspunkt, d.h. vom halben Wert des Konstantstroms I01, betrachtet. Diese Abweichungen bilden einen Wechselstrom, der in Fig. 1 als Kollektorstrom IC bzw. als Emitterstrom IE am ersten Verstärkertransistor 1 eingezeichnet ist, wobei zur Vereinfachung der Betrachtung auch angenommen werden kann, dass bei hinreichend großer Stromverstärkung der Verstärkertransistoren 1, 2 diese Ströme im wesentlichen übereinstimmen. Der beschriebene Wechselstrom, mit IC bzw. IE benannt, fließt somit vom Kollektoranschluss des ersten Verstärkertransistors über dessen Kollektor-Emitter-Strecke, die beiden Emitterwiderstände 3, 4 und die Kollektor-Emitter-Strecke des zweiten Verstärkertransistors, jedoch durch letztere in entgegengesetzter Richtung, verglichen mit dem ersten Verstärkertransistor 1, zum Kollektoranschluss des zweiten Verstärkertransistors 2.

Fig. 2 zeigt eine prinzipielle Darstellung einer mit einer solchen emittergegengekoppelten Differenzverstärkeranordnung erzielbaren Übertragungskennlinie zwischen dem Kollektorstrom IC des ersten Verstärkertransistors 1 und der Differenzspannung UD an den Basisanschlüssen der Verstärkertransistoren 1, 2. Die Emittergegenkopplung durch die Emitterimpedanzen 3, 4 bewirkt eine Linearisierung dieser Kennlinie in einem Bereich um deren Ursprung (UD=0, IC=0), jedoch zeigen sich für größere Aussteuerungen, d.h. größere Werte von UD sowohl in positiver als auch in negativer Richtung Abrundungen, d.h. nichtlineare Einflüsse in dieser Kennlinie.

Eine Berechnung der Kennlinie nach Fig. 2 zeigt, dass in die Übertragungsfunktion der Schaltungsanordnung nach Fig. 1 die Differenz der beiden Basis-Emitter-Spannungen der Verstärkertransistoren 1, 2 einfließt. Diese Differenz der Basis-Emitter-Spannungen ist in nichtlinearer Weise mit dem Kollektorstrom IC verknüpft und liefert dadurch einen nichtlinearen Beitrag für die in Fig. 2 dargestellte Kennlinie.

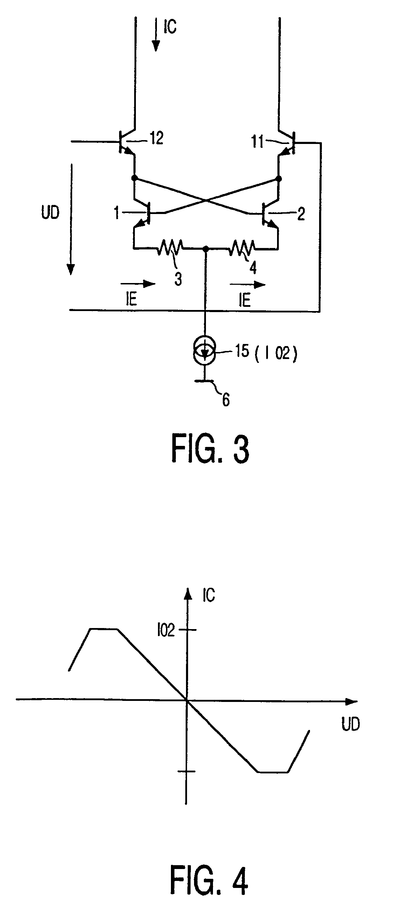

Zur weiteren Linearisierung der Kennlinie eines Differenzverstärkers ist eine Schaltungsanordnung vorgeschlagen worden, wie sie in Fig. 3 dargestellt ist. Dabei sind mit Fig. 1 übereinstimmende Elemente wieder mit denselben Bezugszeichen versehen worden. Auch die Schaltungsanordnung nach Fig. 3 umfasst einen Differenzverstärker mit zwei Verstärkertransistoren 1, 2, deren Emitteranschlüsse über zwei Emitterwiderstände 3, 4 miteinander verbunden sind, wobei an eine Verbindung zwischen den Emitterwiderständen 3, 4 eine gegen Masse 6 führende Konstantstromquelle angeschlossen ist, die einen Konstantstrom I02 liefert und mit dem Bezugszeichen 15 bezeichnet ist. Zu dieser insofern noch mit der Fig. 1 übereinstimmenden Anordnung sind in Fig. 3 ein erster und ein zweiter Emitterfolgertransistor 11 bzw. 12 hinzugefügt. Der Basisanschluss des ersten Verstärkertransistors 1 ist mit einem Emitteranschluss des ersten Emitterfolgertransistors 11 gekoppelt, und der Basisanschluss des zweiten Verstärkertransistors 2 ist mit dem Emitteranschluss des zweiten Emitterfolgertransistors 12 gekoppelt. Diese Kopplung ist in Fig. 3 durch unmittelbare galvanische Verbindung hergestellt. Ferner ist der Emitteranschluss des Emitterfolgertransistors 11 mit dem Kollektoranschluss des zweiten Verstärkertransistors 2 verbunden, und der Emitteranschluss des zweiten Emitterfolgertransistors 12 ist mit dem Kollektoranschluss des ersten Verstärkertransistors 1 verbunden. Dadurch ergibt sich eine Kreuz- oder Rückkopplung in der Art einer bistabilen Kippschaltung. Von den Emitterfolgertransistoren 11, 12 werden jetzt an ihren Kollektoranschlüssen die als Ausgangsströme der Differenzverstärkeranordnung nach Fig. 3 dienenden Kollektorströme abgenommen. Die Emitterströme IE bzw. Kollektorströme IC sind wie in Fig. 1 wieder als Wechselströme verstanden.
Wird bei der Schaltungsanordnung nach Fig. 3 die Übertragungsfunktion als Beziehung zwischen dem Kollektorstrom IC und der Differenzspannung UD berechnet, die nun über den Basisanschlüssen der Emitterfolgertransistoren 11, 12 anliegt, zeigt sich, dass sich die nichtlinearen Einflüsse der Basis-Emitter-Spannungen der Verstärkertransistoren 1, 2 mit entsprechend gegenläufigen, nichtlinearen Einflüssen der Basis-Emitter-Spannungen der Emitterfolgertransistoren 11, 12 derart kompensieren, dass eine wesentlich verbesserte Linearisierung der Kennlinie zwischen dem Kollektorstrom IC und der Differenzspannung UD erzielt wird. Insbesondere heben sich dabei die nichtlinearen Einflüsse der Basis-Emitter-Spannungen des zweiten Emitterfolgertransistors 12 gegen diejenigen des ersten Verstärkertransistors 1 sowie die des ersten Emitterfolgertransistors 11 gegen diejenigen des zweiten Verstärkertransistors 2 auf. Der Kollektorstrom IC und damit der Emitterstrom IE bestimmt sich dann in guter Näherung nach dem ohmschen Gesetz aus der Differenzspannung UD und der Summe der Widerstandswerte der Emitterwiderstände 3, 4. Allerdings ist die Phase zwischen diesen Ein- und Ausgangsgrößen der Differenzverstärkeranordnung nach Fig. 3 gegenüber der Beziehung für die Differenzverstärkeranordnung nach Fig. 1 um 180° gedreht, so dass sich eine Kennlinie mit negativer Steigung ergibt, wie sie in Fig. 4 dargestellt ist. Nichtlineare Ausrundungen dieser Kennlinie bei Annäherung des Wertes des Kollektorstroms IC an den Konstantstrom I02 sind sehr viel geringer als entsprechende Verzerrungen der Kennlinie nach Fig. 2.

Es zeigt sich jedoch, dass die Schaltungsanordnung nach Fig. 3 für bestimmte Betriebssituationen Nachteile aufweist. So ist beobachten, dass bei einer Aussteuerung der Anordnung mit einer Differenzspannung, die etwa 500 mV (für bipolare Siliciumtransistoren) übersteigt, die Verstärkertransistoren 1, 2 in die Sättigung geraten. Bei einer in üblicher Weise vorgenommenen Integration einer solchen Differenzverstärkeranordnung und damit der Verstärkertransistoren 1, 2 auf einem Halbleiterkristall können in diesem Betriebsfall im Substrat des Halbleiterkristalls hohe Querströme entstehen, die zu unerwünschten Effekten führen und daher auf jeden Fall zu vermeiden sind. Bereits aus diesem Grunde ist die Aussteuerung einer solchen Differenzverstärkeranordnung sehr eingeschränkt. Ferner beinhaltet der Aufbau der Differenzverstärkeranordnung nach Fig. 3 in der Art einer bistabilen Kippschaltung, d.h. mit einer geschlossen Rückkopplungsschleife, stets die Gefahr einer Instabilität, insbesondere, wenn für die Emitterwiderstände 3, 4 relativ kleine Widerstandswerte gewählt werden, was beispielsweise erforderlich werden kann, um bei einem vorgegebenen Kollektorstrom die über den Emitterwiderständen 3, 4 auftretenden Spannungen zu begrenzen. Im Grenzfall zeigt die Schaltungsanordnung nach Fig. 3 dann tatsächlich das Verhalten einer bistabilen Kippschaltung.

Das relativ frühe Eintreten der Verstärkertransistoren 1, 2 in die Sättigung bei der Schaltungsanordnung nach Fig. 3 bewirkt außerdem, daß sich bei darüber hinausgehender Aussteuerung die Phase des Kollektorstroms IC wieder zurück in die Phasenlage gemäß der Anordnung nach Fig. 1 und 2 zurück dreht. Wird nun die Differenzverstärkeranordnung nach Fig. 3 in ein geschlossenes Regelsystem eingebunden, kann diese bei Übersteuerung auftretende Phasendrehung zu Instabilitäten des gesamten Regelsystems führen.

Aus der Druckschrift Chung W -S et al., "Bipolar Linear Transconductor", Electronics Letters, GB, IEE Stevenage, Bd. 26, Nr. 10, 1. Mai 1990 (1990-05-01), Seiten 619-621, XP000124177, ISSN: 0013-5194, insbesondere aus der dortigen Fig. 3 mit zugehöriger Beschreibung, ist ein bipolarer linearer Transkonduktor bekannt mit
- einem ersten Verstärkertransistor (mit dem dortigen Bezugszeichen Q_{1A}), dessen Basisanschluß mit einem Emitteranschluß eines ersten Emitterfolgertransistors (mit dem dortigen Bezugszeichen Q₃) gekoppelt ist,
- einem zweiten Verstärkertransistor (mit dem dortigen Bezugszeichen Q_{2A}), dessen Basisanschluß mit einem Emitteranschluß eines zweiten Emitterfolgertransistors (mit dem dortigen Bezugszeichen Q₄) gekoppelt ist,
- einer ersten Emitterimpedanz (Emitterwiderstände mit dem dortigen Bezugszeichen R_{E}), über die Emitteranschlüsse des ersten (dortiges Bezugszeichen Q_{1A}) und des zweiten (dortiges Bezugszeichen Q_{2A}) Verstärkertransistors miteinander gekoppelt sind,
wobei Basisanschlüssen der Emitterfolgertransistoren (dortige Bezugszeichen Q₃ und Q₄) eine Differenzspannung (mit dem dortigen Bezugszeichen V₁) zuführbar ist.

Der Transkonduktor nach D 1 zeigt ferner vier Stromspiegel mit den dortigen Bezugszeichen Q₅ und Q₆ bzw. Q₇ und Q₈ bzw. Q₉ und Q₁₀ bzw. Q₁₁ und Q₁₂. Dabei wird durch zwei dieser Stromspiegel, welche die dortigen Bezugszeichen Q₅ und Q₆ bzw. Q₉ und Q₁₀ tragen, ein Kollektorstrom in einem Kollektoranschluß des zweiten Verstärkertransistors (mit dem dortigen Bezugszeichen Q_{2A}) in den Emitteranschluß des ersten Emitterfolgertransistors (mit dem dortigen Bezugszeichen Q₃) gespiegelt. Entsprechend wird durch die beiden anderen dieser Stromspiegel, die die dortigen Bezugszeichen Q₇ und Q₈ bzw. Q₁₁ und Q₁₂ tragen, ein Kollektorstrom in einem Kollektoranschluß des ersten Verstärkertransistors (mit dem dortigen Bezugszeichen Q_{1A}) in den Emitteranschluß des zweiten Emitterfolgertransistors (mit dem dortigen Bezugszeichen Q₄) gespiegelt. Begrifflich können diese vier Stromspiegel als eine Stromübertragungsschaltung aufgefaßt werden.

Ausgehend von diesem Stand der Technik besteht die Aufgabe der vorliegenden Erfindung darin, bei einem Differenzverstärker, der eine auch über größere Aussteuerungsbereiche lineare Kennlinie aufweist und einen stabilen Betrieb ermöglicht, eine weitere Schaltungsvereinfachung zu erzielen.

Erfindungsgemäß wird diese Aufgabe bei einem Differenzverstärker der gattungsgemäßen Art, in dem durch die Stromübertragungsschaltung dem Emitteranschluß des ersten Emitterfolgertransistors spannungsentkoppelt ein erster Strom zugeführt wird, der zu einem Kollektorstrom in einem Kollektoranschluß des zweiten Verstärkertransistors in einem durch die Gestaltung des ersten Emitterfolgertransistors und des zweiten Verstärkertransistors derart vorbestimmten Verhältnis steht, daß eine am ersten Emitterfolgertransistor auftretende mit einer am zweiten Verstärkertransistor auftretenden Basis-Emitter-Spannung wenigstens nahezu übereinstimmt, und dem Emitteranschluß des zweiten Emitterfolgertransistors spannungsentkoppelt ein zweiter Strom zugeführt wird, der zu einem Kollektorstrom in einem Kollektoranschluß des ersten Verstärkertransistors in einem durch die Gestaltung des zweiten Emitterfolgertransistors und des ersten Verstärkertransistors derart vorbestimmten Verhältnis steht, daß eine am zweiten Emitterfolgertransistor auftretende mit einer am ersten Verstärkertransistor auftretenden Basis-Emitter-Spannung wenigstens nahezu übereinstimmt, dadurch gelöst, daß die Stromübertragungsschaltung einen ersten Zweig zum Ableiten des ersten Stromes aus dem Kollektorstrom des ersten Verstärkertransistors und einen zweiten Zweig zum Ableiten des zweiten Stromes aus dem Kollektorstrom des zweiten Verstärkertransistors umfaßt und daß der erste und der zweite Zweig je wenigstens eine Stromspiegelanordnung und je wenigstens eine Stromumkehrstufe umfassen.

Diese erfindungsgemäße Ausbildung des Differenzverstärkers gewährleistet die Einhaltung einer korrekten Phasenbeziehung der Ströme bei gleichzeitiger Schaltungsvereinfachung, da eine Stromumkehr an die Stelle einer Stromspiegelung tritt. Die Vermeidung einer Stromspiegelung erhöht dabei zusätzlich die Genauigkeit der Signalübertragung.

Der Erfindung liegt die Erkenntnis zugrunde, daß die bei der in Fig. 3 dargestellten Differenzverstärkeranordnung auftretende Sättigung der Verstärkertransistoren 1, 2 eine zentrale Ursache sowohl für die begrenzte Aussteuerbarkeit dieser Differenzverstärkeranordnung als auch für deren Neigung zu Instabilitäten darstellt. Diese Sättigung wird beeinflußt durch die sich im Betrieb bei stärkerer Aussteuerung der Differenzverstärkeranordnung, d.h. Erhöhung des Wertes der Differenzspannung UD, einstellenden elektrischen Potentiale an den Basisanschlüssen und den Kollektoranschlüssen der Verstärkertransistoren 1, 2.

Durch die erfindungsgemäße Ausbildung der Differenzverstärkeranordnung mit der beschriebenen Stromübertragungsschaltung gelingt es jedoch, einerseits die sich bei der vorbeschriebenen Differenzverstärkeranordnung im Betrieb einstellenden Ströme, insbesondere Emitterströme und Kollektorströme, zumindest im wesentlichen unverändert zu erhalten, ohne daß sich jedoch die die Sättigung beeinflussenden elektrischen Potentiale an den Kollektor-, Basis- bzw. Emitteranschlüssen der Verstärkertransistoren ausbilden können. Damit wird einerseits eine Linearisierung erreicht, wie sie sich bei der Differenzverstärkeranordnung nach Fig. 3 ergibt, andererseits jedoch eine verbesserte Aussteuerbarkeit und eine verbesserte Stabilität erzielt. Der erfindungsgemäße Differenzverstärker ist insgesamt relativ einfach aufgebaut und insbesondere auf einem Halbleiterkörper integrierbar. Er kann mit sehr geringen Versorgungsspannungen betrieben werden.

Vorteilhaft umfaßt die Stromübertragungsschaltung im erfindungsgemäßen Differenzverstärker zum Ableiten des ersten bzw. zweiten Stromes aus den Kollektorströmen der Verstärkertransistoren wenigstens eine Stromspiegelanordnung. Allgemein stellt eine Stromspiegelanordnung eine sehr einfache und wirkungsvolle Einrichtung dar, um insbesondere in einer integrierten Halbleiterschaltung einen Strom von einem elektrischen Potential auf ein anderes, davon entkoppeltes elektrisches Potential zu übertragen.

In einer Ausgestaltung des Differenzverstärkers umfaßt die Stromübertragungsschaltung einen ersten Zweig zum Ableiten des ersten Stromes aus dem Kollektorstrom des zweiten Verstärkertransistors und einen zweiten Zweig zum Ableiten des zweiten Stromes aus dem Kollektorstrom des ersten Verstärkertransistors. Vergleichbar mit der Differenzverstärkeranordnung nach Fig. 3 werden somit Stromkopplungen zwischen den Kollektoranschlüssen der Verstärkertransistoren und den Emitteranschlüssen der Emitterfolgertransistoren über Kreuz vorgenommen, bezogen auf die Kopplung der Basisanschlüsse der Verstärkertransistoren mit den Emitteranschlüssen der Emitterfolgertransistoren. Der dem Emitteranschluß des ersten Emitterfolgertransistors zugeführte erste Strom wird bei diesem Differenzversttirker somit im ersten Zweig aus dem Kollektorstrom des zweiten Verstärkertransistors abgeleitet, und entsprechend wird der zweite Strom, der dem Emitteranschluß des ersten Emitterfolgertransistors zugeführt wird, im zweiten Zweig vom Kollektoranschluß des ersten Verstärkertransistors abgeleitet. Vorzugsweise erfolgt diese Ableitung über Stromspiegelanordnungen, wobei der erste und der zweite Zweig je wenigstens eine Stromspiegelanordnung umfassen.

Insbesondere in einer symmetrisch aufgebauten Differenzverstärkeranordnung sind die in den Kollektor-Emitter-Strecken der Verstärkertransistoren fließenden Wechselströme einander gleich. Damit kann der erste Strom ebenso aus dem Kollektorstrom des ersten Verstärkertransistors und entsprechend der zweite Strom aus dem Kollektorstrom des zweiten Verstärkertransistors abgeleitet werden. In einer demgemäßen Ausbildung des erfindungsgemäßen Differenzverstärkers umfaßt die Stromübertragungsschaltung einen ersten Zweig zum Ableiten des ersten Stromes aus dem Kollektorstrom des ersten Verstärkertransistors und einen zweiten Zweig zum Ableiten des zweiten Stromes aus dem Kollektorstrom des zweiten Verstärkertransistors.

Da jedoch der Kollektorstrom im zweiten Verstärkertransistor, d.h. der Wechselstrom, umgekehrt zum Kollektorstrom im ersten Verstärkertransistor fließt, muß zur Einhaltung einer korrekten Phasenbeziehung der Ströme eine entsprechende Stromumkehrung berücksichtigt werden. Dies erfolgt dadurch, daß der erste und der zweite Zweig je wenigstens eine Stromspiegelanordnung und zusätzlich je wenigstens eine Stromumkehrstufe umfassen.

Beim erfindungsgemäßen Differenzverstärker können Ausgangsströme an unterschiedlichen Schaltungspunkten abgegriffen bzw. können unterschiedliche Vorrichtungen zum Abgreifen von Ausgangsströmen vorgesehen werden. In einer ersten Ausführung ist dazu der erfindungsgemäße Differenzverstärker gekennzeichnet durch
- einen dritten Verstärkertransistor, dessen Basisanschluß mit dem Basisanschluß des ersten Verstärkertransistors gekoppelt ist,
- einen vierten Verstärkertransistor, dessen Basisanschluß mit dem Basisanschluß des zweiten Verstärkertransistors gekoppelt ist,
- wenigstens einer zweiten Emitterimpedanz über die Emitteranschlüsse des dritten und des vierten Verstärkertransistors miteinander gekoppelt sind, sowie dadurch, daß
- aus Kollektoranschlüssen des dritten und des vierten Verstärkertransistors Ausgangsströme des Differenzverstärkers ableitbar sind.

Bei dieser Ausbildung des erfindungsgemäßen Differenzverstärkers dient die Anordnung aus erstem und zweitem Verstärkertransistor nur der Linearisierung der Übertragungsfunktion des Differenzverstärkers. Für die Verstärkung des als Nutzsignal dem erfindungsgemäßen Differenzverstärker in dieser Ausbildung zu entnehmenden Ausgangsstroms, d.h. Kollektorstroms von Verstärkertransistoren, ist eine zusätzliche Differenzverstärkeranordnung aus dem dritten und dem vierten Verstärkertransistor vorgesehen, die zur ersten Differenzverstärkeranordnung aus dem ersten und zweiten Verstärkertransistor parallel angesteuert wird. Vorzugsweise sind diese beiden Differenzverstärkeranordnungen identisch dimensioniert.

Eine andere Ausgestaltung des erfindungsgemäßen Differenzverstärkers ergibt sich dadurch, daß je eine der Stromspiegelanordnungen des ersten und des zweiten Zweiges der Stromübertragungsschaltung zum Ableiten je eines der Ausgangsströme des Differenzverstärkers ausgebildet ist. Hierbei sind anstelle der vorbeschriebenen, zusätzlichen Differenzverstärkeranordnung in den genannten Stromspiegelanordnungen zusätzliche Strompfade eingerichtet, deren Ströme als Ausgangsströme entnommen werden können.

In einer anderen Ausbildung des erfindungsgemäßen Differenzverstärkers können dessen Ausgangsströme auch aus Kollektoranschlüssen der Emitterfolgertransistoren abgeleitet werden. In diesem Fall können zusätzliche Einrichtungen zum Ableiten der Ausgangsströme entfallen.

In der Zeichnung, in der übereinstimmende Elemente mit denselben Bezugszeichen versehen sind, und in der
Fig. 1 eine beschriebene erste, emittergekoppelte Differenzverstärkeranordnung,
Fig. 2 die Kennlinie der Anordnung nach Fig. 1,
Fig. 3 eine zweite beschriebene, linearisierte Differenzverstärkeranordnung,
Fig. 4 die Kennlinie der Anordnung nach Fig. 3,
Fig. 5 ein weiteres Beispiel eines Differenzverstärkers und
Fig. 6 die Kennlinie der Anordnung nach Fig. 5
   zeigen,
   ist weiterhin in
Fig. 7 ein Ausführungsbeispiel eines erfindungsgemäßen Differenzverstärkers dargestellt.
   Dabei ergibt sich für das Ausführungsbeispiel von Fig. 7 ebenfalls die in Fig. 6 dargestellte Kennlinie.

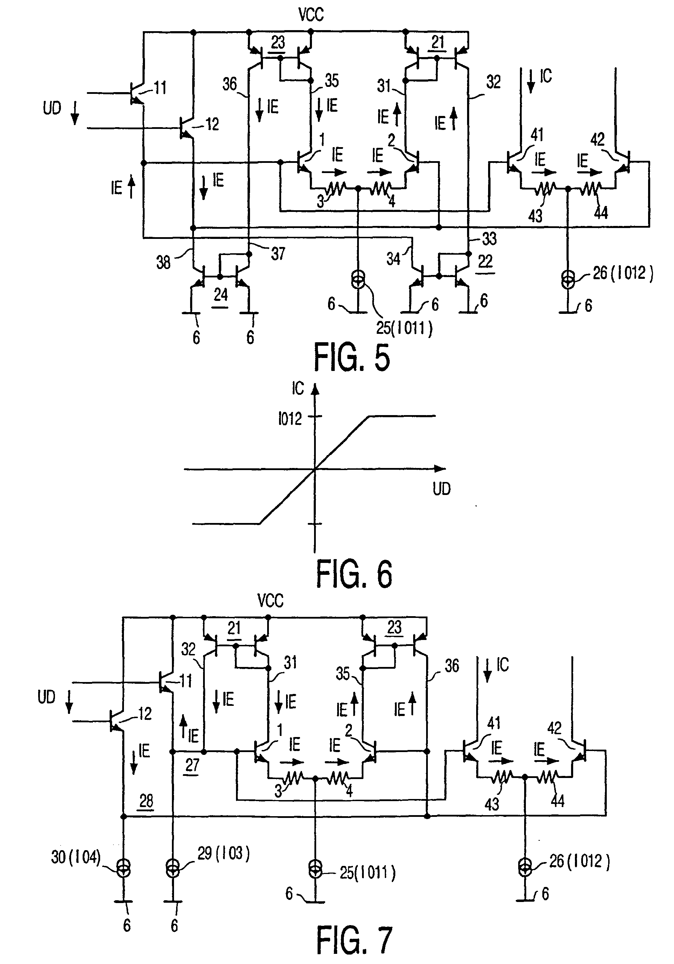

Der in Fig. 5 dargestellte Differenzverstärker umfaßt wiederum die Anordnung zweier über zwei Emitterwiderstände 3, 4 emittergekoppelter Verstärkertransistoren 1, 2. Vom Verbindungspunkt der Emitterwiderstände 3, 4 führt eine Konstantstromquelle 25 an Masse 6. Die Konstantstromquelle 25 führt einen Gleichstrom der Größe I011. Der erste Verstärkertransistor 1 ist mit seinem Basisanschluß mit dem Emitteranschluß eines ersten Emitterfolgertransistors 11 gekoppelt, und der Basisanschluß des zweiten Verstärkertransistors 2 ist an den Emitteranschluß eines zweiten Emitterfolgertransistors 12 gekoppelt. Zwischen den Basisanschlüssen der Emitterfolgertransistoren 11, 12 wird wieder eine als Eingangsspannung des Differenzverstärkers nach Fig. 5 fungierende Differenzspannung UD

Die Anordnung nach Fig. 5 umfaßt weiterhin eine Stromübertragungsschaltung, welche vier Stromspiegelanordnungen 21, 22, 23 bzw. 24 umfaßt. Darin bilden die erste Stromspiegelanordnung 21 und die zweite Stromspiegelanordnung 22 einen ersten Zweig der Stromübertragungsschaltung, wohingegen die dritte Stromspiegelanordnung 23 und die vierte Stromspiegelanordnung 24 einen zweiten Zweig der Stromübertragungsschaltung bilden. Durch den ersten Zweig 21, 22 der Stromübertragungsschaltung wird dem Emitteranschluß des ersten Emitterfolgertransistors 11 ein erster Strom zugeführt, der durch die Stromspiegelanordnungen 21, 22 aus dem Kollektorstrom des zweiten Verstärkertransistors 2 abgeleitet wird und dadurch zu diesem in einem vorbestimmten Verhältnis steht. Der Einfachheit halber kann für das Ausführungsbeispiel nach Fig. 5 angenommen werden, daß der erste Emitterfolgertransistor 11, der zweite Verstärkertransistor 2 und die Stromspiegelanordnungen 21, 22 derart gestaltet sind, daß bis auf Basisströme der Kollektorstrom des zweiten Verstärkertransistors mit dem ersten Strom übereinstimmt. In jedem Fall wird erreicht, daß bei der gewählten Dimensionierung eine am ersten Emitterfolgertransistor 11 auftretende Basis-Emitter-Spannung mit einer am zweiten Verstärkertransistor 2 auftretenden Basis-Emitter-Spannung wenigstens nahezu übereinstimmt. Dadurch heben sich in einer der Fig. 3 entsprechenden Weise die Einflüsse dieser Basis-Emitter-Spannungen heraus, so dass deren nichtlineare Einflüsse keinen Niederschlag in der Kennlinie des Differenzverstärkers finden.

Um dieses zu erreichen, ist ein Eingang 31 der ersten Stromspiegelanordnung 21 mit dem Kollektoranschluss des zweiten Verstärkertransistors 2 verbunden. Die erste Stromspiegelanordnung 21 umfasst zwei basisgekoppelte pnp-Transistoren, deren Emitteranschlüsse an einen Anschluss für eine Versorgungsspannung VCC geführt sind. Einer dieser Transistoren ist zwischen seinem den Eingang 31 der ersten Stromspiegelanordnung 21 bildenden Kollektoranschluss und seinem Basisanschluss kurzgeschlossen; der zweite Transistor bildet mit seinem Kollektoranschluss einen Ausgang 32 der ersten Stromspiegelanordnung 21. Diese einfachste Form einer Stromspiegelanordnung ist lediglich beispielhaft dargestellt; für eine präzisere Stromübertragung können anstelle dieser Anordnung beispielsweise sogenannte Wilson-Stromspiegel zum Einsatz gelangen.
Der Ausgang 32 der ersten Stromspiegelanordnung 21 ist mit einem Eingang 33 der zweiten Stromspiegelanordnung 22 verbunden. Für die zweite Stromspiegelanordnung 22 ist eine der ersten Stromspiegelanordnung 21 vergleichbare Schaltung dargestellt, die jedoch npn-Transistoren aufweist, deren Emitteranschlüsse an Masse 6 führen. Ansonsten gilt für die zweite Stromspiegelanordnung 22 das zu der ersten Stromspiegelanordnung 21 Gesagte. Am Ausgang 34 der zweiten Stromspiegelanordnung 22 wird dann der erste Strom abgegriffen und dem Emitteranschluss des ersten Emitterfolgertransistors 11 zugeleitet. Dieser erste Strom ist als Emitterstrom IE eingezeichnet und entspricht bis auf die erwähnten Basisströme dem Emitterstrom IE im Differenzverstärker, d.h. in den Verstärkertransistoren 1, 2.

Der zweite Zweig 23, 24 der Stromübertragungsschaltung im Ausführungsbeispiel nach Fig. 5 entspricht in seinem Aufbau und in seiner Funktionsweise dem ersten Zweig 21, 22. Durch den zweiten Zweig 23, 24 wird entsprechend aus dem Kollektorstrom des ersten Verstärkertransistors 1 ein zweiter Strom abgeleitet und dem Emitteranschluss des zweiten Emitterfolgertransistors 12 zugeführt. Dazu weist die dritte Stromspiegelanordnung 23 einen Eingang 35 auf, der mit dem Kollektoranschluss des ersten Verstärkertransistors 1 verbunden ist. Ein Ausgang 36 der dritten Stromspiegelanordnung 23 ist mit einem Eingang 37 der vierten Stromspiegelanordnung 24 verbunden. Am mit dem Emitteranschluss des zweiten Emitterfolgertransistors 12 verbundenen Ausgang 38 der vierten Stromspiegelanordnung 24 wird der zweite Strom abgegeben. Im Ausführungsbeispiel nach Fig. 5 entspricht auch der zweite Strom dem Emitterstrom IE bis auf die genannten Basisströme.

Grundsätzlich können die Verstärkertransistoren 1, 2, die Emitterfolgertransistoren 11, 12 und die Stromspiegel 21 bis 24 unterschiedlich dimensioniert werden, so lange diese Dimensionierungen derart gewählt sind, dass der erste Strom zum Kollektorstrom des zweiten Verstärkertransistors 2 und der zweite Strom zum Kollektorstrom des ersten Verstärkertransistors 1 in derartigem Verhältnis zueinander stehen, dass die genannten Basis-Emitter-Spannungen an den Verstärkertransistoren 1, 2 und den Emitterfolgertransistoren 11, 12 einander in ihren nichtlinearen Einflüssen kompensieren. Diese Verhältnisse können insbesondere durch die Stromspiegelverhältnisse der Stromspiegelanordnungen 21 bis 24 und die Wahl der Flächen der Verstärkertransistoren 1, 2 und der Emitterfolgertransistoren 11, 12 eingestellt werden. Auch können anstelle der Emitterwiderstände 3, 4 beliebige Impedanzen beliebigen Wertes eingesetzt werden. Vorzugsweise werden jedoch ohmsche Emitterwiderstände übereinstimmender Werte und gleiche Transistoren verwendet. Die Stromspiegelanordnungen 21 bis 24 haben bevorzugt ein Stromspiegelverhältnis von 1. Der Emitterstrom IE ergibt sich dann aus der Summe der Emitterwiderstände 3, 4 und der Differenzspannung UD nach dem ohmschen Gesetz.

Dadurch, dass das elektrische Potential am Eingang 31 der ersten Stromspiegelanordnung 21 an demjenigen am Ausgang 34 der zweiten Stromspiegelanordnung 22 unbeeinflusst ist, wird verhindert, dass der zweite Verstärkertransistor 2 in die Sättigung gerät. Entsprechendes gilt für den zweiten Zweig 23, 24 der Stromübertragungsschaltung und den ersten Verstärkertransistors 1.

Die Anordnung nach Fig. 5 enthält weiterhin einen dritten und einen vierten Verstärkertransistor 41 bzw. 42, die über zwei in Reihe angeordnete Emitterwiderstände 43, 44 emittergekoppelt sind. Anstelle der Emitterwiderstände 43, 44 können allgemein auch beliebige zweite Emitterimpedanzen eingesetzt werden. Vom Verbindungspunkt zwischen den Emitterwiderständen 43, 44 führt eine Konstantstromquelle 26, die einen Konstantstrom I012 führt, an Masse 6.

Vorzugsweise ist die Anordnung aus den Verstärkertransistoren 41, 42, den Emitterwiderständen 43, 44 und der Konstantstromquelle 26 identisch zu den Verstärkertransistoren 1, 2 und deren Beschaltung dimensioniert. Damit stimmen auch die Konstantströme I011 und I012 überein. Da den Basisanschlüssen der Verstärkertransistoren 41, 42 auch dieselbe Differenzspannung zugeführt wie den Basisanschlüssen der Verstärkertransistoren 1, 2, stimmt der Kollektorstrom IC bzw. der Emitterstrom IE in dieser Differenzanordnung 41, 42 mit den zuvor an den Verstärkertransistoren 1, 2 beschriebenen Strömen überein. Der Kollektorstrom IC an den Verstärkertransistoren 41, 42 wird dann der Schaltung gemäß Fig. 5 als Ausgangsstrom des Differenzverstärkers entnommen. Die Kennlinie zwischen diesem Ausgangsstrom - Kollektorstrom IC - und der Differenzspannung UD an den Basisanschlüssen der Emitterfolgertransistoren 11, 12 zeigt Fig. 6. Es ergibt sich eine sehr weitgehend lineare Kennlinie ohne auffällige, nichtlineare "Verrundungen" in den oberen Aussteuerungsbereichen. Beim Erreichen der betragsmäßig höchsten Werte für den Kollektorstrom IC bleibt auch bei stärkerer Aussteuerung dieser Strom stabil.

Fig. 7 zeigt als Ausführungsbeispiel der Erfindung eine Abwandlung der Schaltungsanordnung nach Fig. 5, in dem mit Fig. 5 übereinstimmende Elemente wieder mit denselben Bezugszeichen versehen sind. Dies betrifft insbesondere die Emitterfolgertransistoren 11, 12, die Verstärkertransistoren 1, 2, 41, 42, die Emitterwiderstände 3, 4, 43, 44 und die zugehörigen Konstantstromquellen 25, 26.

Beim Ausführungsbeispiel nach Fig. 7 ist eine Stromübertragungsschaltung dargestellt, deren erster Zweig zum Ableiten des ersten Stromes aus dem Kollektorstrom des ersten Verstärkertransistors 1 und dessen zweiter Zweig zum Ableiten des zweiten Stromes aus dem Kollektorstrom des zweiten Verstärkertransistors 2 eingerichtet ist. Dazu umfaßt der erste Zweig der Ausführungsform der Stromübertragungsschaltung gemäß Fig. 7 außer der ersten Stromspiegelanordnung 21 eine erste Stromumkehrstufe 27, die hier an die Stelle der zweiten Stromspiegelanordnung 22 tritt. Entsprechend umfaßt der zweite Zweig der Stromübertragungsschaltung nach Fig. 7 außer der dritten Stromspiegelanordnung 23 eine zweite Stromumkehrstufe 28. Die erste Stromumkehrstufe 27 umfasst im wesentlichen eine Konstantstromquelle 29, die einen Konstantstrom I03 führt. Die Konstantstromquelle 29 ist mit einem ihrer Anschlüsse an eine Verbindung zwischen dem Emitteranschluss des ersten Emitterfolgertransistors 11 und dem Ausgang 32 der ersten Stromspiegelanordnung 21 angeschlossen. Mit ihrem zweiten Anschluss ist die Konstantstromquelle 29 an Masse 6 angeschlossen. Entsprechend umfasst die zweite Stromumkehrstufe 28 im zweiten Zweig der Stromübertragungsschaltung nach Fig. 7 im wesentlichen eine Konstantstromquelle 30, die einen Konstantstrom I04 liefert und einseitig an Masse 6 angeschlossen ist, während sie anderseitig mit einem Verbindungspunkt zwischen dem Emitteranschluss des zweiten Emitterfolgertransistors 12 und dem Ausgang 36 der dritten Stromspiegelanordnung 23 verbunden ist. Die Basisanschlüsse der Verstärkertransistoren 1, 2 sind unverändert mit den Emitteranschlüssen der Emitterfolgertransistoren 11, 12 verbunden.

In der Stromübertragungsschaltung gemäß Fig. 7 wird in deren erstem Zweig 21, 27 der Kollektorstrom vom ersten Verstärkertransistor 1 zunächst dem Eingang 31 der ersten Stromspiegelanordnung 21 zugeführt und darin auf den Ausgang 32 gespiegelt. Dieser Ausgang 32 ist durch die Verbindung in der Stromumkehrstufe 27 außer mit den Basisanschlüssen der Verstärkertransistoren 1, 41, die keinen nennenswerten Strom aufnehmen, und der Konstantstromquelle 29, die nur einen Konstantstrom I03 führt, nur mit dem Emitteranschluss des ersten Emitterfolgertransistors 11 verbunden. Somit werden wenigstens nahezu alle Wechselstromanteile des Emitterstroms IE des ersten Verstärkertransistors 1 aus dem Ausgang 32 der ersten Stromspiegelanordnung 21 in den Emitteranschluss des ersten Emitterfolgertransistors 11 fließen. In Fig. 7 sind diese Stromrichtungen wieder wie in den vorherigen Figuren durch Pfeile markiert. Auf entsprechende Weise wird auch der Kollektorstrom des zweiten Verstärkertransistors 2, dessen Wechselstromanteil demjenigen des ersten Verstärkertransistors 1 entspricht und ebenfalls mit IE bezeichnet ist, über die dritte Stromspiegelanordnung 23 und die zweite Stromumkehrstufe 28 des zweiten Zweiges dem Emitteranschluss des zweiten Emitterfolgertransistors 12 zugeführt. Die Entkopplung der elektrischen Potentiale der Emitteranschlüsse der Emitterfolgertransistoren 11 bzw. 12 von denjenigen der Kollektoranschlüsse der Verstärkertransistoren 1 bzw. 2 erfolgt hier durch die Stromspiegelanordnungen 21, 23 allein.

Das Ausführungsbeispiel gemäß Fig. 7 enthält gegenüber dem Ausführungsbeispiel nach Fig. 5 eine Verminderung der Anzahl der benötigten Schaltungselemente und damit eine Schaltungsvereinfachung. Die Emitterimpedanzen 3, 4, 43, 44 können auch hier wieder beliebig gewählt werden; vorzugsweise werden jedoch ohmsche Emitterwiderstände übereinstimmender Werte gewählt. Auch alle Konstantströme I03, I04, I011, I012 der Konstantstromquellen 29, 30, 25 bzw. 26 sind vorzugsweise gleich gewählt. Damit stimmen auch die Emitterströme des ersten Verstärkertransistors 1 und des zweiten Emitterfolgertransistors 12 überein, ebenso diejenigen des zweiten Verstärkertransistors 2 und des ersten Emitterfolgertransistors 11. Die Kennlinie zeigt Fig. 6.

Auch beim Ausführungsbeispiel nach Fig. 7 dient zur Verstärkung des Nutzsignals, d.h. zur Lieferung der Ausgangsströme, das Verstärkertransistorenpaar 41, 42. Grundsätzlich liefern auch hier wieder die Verstärkertransistoren 1, 2 die gewünschten, linearisierten Kollektorströme. Diese werden jedoch als Eingangsströme für die Stromspiegelanordnungen 21, 23 benötigt. Zur Ableitung der Ausgangsströme könnten aber auch die Kollektorströme der Emitterfolgertransistoren 11, 12 herangezogen werden oder eine entsprechende Erweiterung der Stromspiegelanordnungen 21, 23 vorgenommen werden. Auch beim Ausführungsbeispiel nach Fig. 7 können im übrigen ohne Nachteile für die Stabilität sehr kleine Widerstandswerte für die Emitterwiderstände 3, 4 zum Einsatz gelangen.

## Patentansprüche

1. Differenzverstärker mit wenigstens
- einem ersten Verstärkertransistor (1), dessen Basisanschluß mit einem Emitteranschluß eines ersten Emitterfolgertransistors (11) gekoppelt ist,
- einem zweiten Verstärkertransnstor (2), dessen Basisanschluß mit einem Emitteranschluß eines zweiten Emitterfolgertransistors (12) gekoppelt ist,
- einer ersten Emitterimpedanz (3, 4), über die Emitteranschlüsse des ersten (1) und des zweiten (2) Verstärkertransistors miteinander gekoppelt sind,
wobei Basisanschlüssen der Emitterfolgertransistoren (11, 12) zum Steuern des Differenzverstärkers eine Differenzspannung (UD) zuführbar ist,
mit einer Stromübertragungsschaltung (21, 23, 27, 28), durch die dem Emitteranschluß des ersten Emitterfolgertransistors (11) spannungsentkoppelt ein erster Strom zugeführt wird, der zu einem Kollektorstrom in einem Kollektoranschluß des zweiten Verstärkertransistors (2) in einem durch die Gestaltung des ersten Emitterfolgertransistors (11) und des zweiten Verstärkertransistors (2) derart vorbestimmten Verhältnis steht, daß eine am ersten Emitterfolgertransistor (11) auftretende mit einer am zweiten Verstärkertransistor (2) auftretenden Basis-Emitter-Spannung wenigstens nahezu übereinstimmt, und durch die dem Emitteranschluß des zweiten Emitterfolgertransistors (12) spannungsentkoppelt ein zweiter Strom zugeführt wird, der zu einem Kollektorstrom in einem Kollektoranschluß des ersten Verstärkertransistors (1) in einem durch die Gestaltung des zweiten Emitterfolgertransistors (11) und des ersten Verstärkertransistors (1) derart vorbestimmten Verhältnis steht, daß eine am zweiten Emitterfolgertransistor(12) auftretende mit einer am ersten Verstärkertransistor (1) auftretenden Basis-Emitter-Spannung wenigstens nahezu übereinstimmt,
**dadurch gekennzeichnet,**
**daß** die Stromübertragungsschaltung (21, 23, 27, 28) einen ersten Zweig (21, 27) zum Ableiten des ersten Stromes aus dem Kollektorstrom des ersten Verstärkertransistors(1) und einen zweiten Zweig (23, 28)zum Ableiten des zweiten Stromes aus dem Kollektorstrom des zweiten Verstärkertransistors (2) umfaßt und daß der erste (21, 27) und der zweite (23, 28) Zweig je wenigstens eine Stromspiegelanordnung (21, 23) und je wenigstens eine Stromumkehrstufe (27, 28) umfassen.

2. Differenzverstärker nach Anspruch 1,
**gekennzeichnet durch**
- einen dritten Verstarkertraosistor (41), dessen Basisanschluß mit dem Basisanschluß des ersten Verstärkertransistors (1) gekoppelt ist,
- einen vierten Verstärkertransistor 42), dessen Basisanschluß mit dem Basisanschluß des zweiten Verstärkertransistors (2) gekoppelt ist,
- wenigstens einer zweiten Emitterimpedanz (43, 44), über die Emitteranschlüsse des dritten (41) und des vierten (42) Verstärkertransistors miteinander gekoppelt sind, sowie **dadurch**, daß
- aus Kollektoranschlüssen des dritten (41) und des vierten (42) Verstärkertransistors Ausgangsströme des Differenzverstärkers ableitbar sind.

3. Differenzverstärker nach Anspruch 1,
**dadurch gekennzeichnet,**
**daß** je eine der Stromspiegelanordnungen (21, 23) des ersten (21, 27) und des zweiten (23, 28) Zweiges der Stromübertragungsschaltung (21, 23, 27, 28) zum Ableiten je eines der Ausgangsströme des Differenzverstärkers ausgebildet ist.

4. Differenzverstärker nach Anspruch 1,
**dadurch gekennzeichnet,**
**daß** Ausgangsströme des Differenzverstärkers aus Kollektoranschlüssen der Emitterfolgertransistoren (11, 12) abgeleitet werden.

## Claims

1. A differential amplifier comprising at least:
- a first amplifier transistor (1) whose base terminal is coupled to an emitter terminal of a first emitter-follower transistor (11),
- a second amplifier transistor (2) whose base terminal is coupled to an emitter terminal of a second emitter-follower transistor (12),
- a first emitter impedance (3, 4) across which emitter terminals of the first (1) and the second (2) amplifier transistor are coupled to each other,
while base terminals of the emitter-follower transistors (11, 12) can be supplied with a differential voltage (UD) for controlling the differential amplifier,
comprising a power transfer circuit (21, 23, 27, 28) by which the emitter terminal of the first emitter-follower transistor (11), while being voltage decoupled, is supplied with a first current which has a proportion to a collector current in a collector terminal of the second amplifier transistor (2) that is predefined by the configuration of the first emitter-follower transistor (11) and of the second amplifier transistor (2), so that a base-emitter voltage occurring on the first emitter-follower transistor (11) at least substantially matches a base-emitter voltage occurring on the second amplifier transistor (2) and by which a second current is applied to the emitter terminal of the second emitter-follower transistor (12) which is voltage decoupled, which second current has a proportion to a collector current in a collector terminal of the first amplifier transistor (1) that is predefined by the configuration of the second emitter-follower transistor (11) and of the first amplifier transistor (1), so that a base-emitter voltage occurring on the second emitter-follower transistor (12) at least substantially matches a base-emitter voltage occurring on the first amplifier transistor (1),
**characterized in that** the power transfer circuit (21, 23, 27, 28) comprises a first branch (21, 27) for deriving the first current from the collector current of the first amplifier transistor (1) and a second branch (23, 28) for deriving the second current from the collector current of the second amplifier transistor (2) and **in that** the first (21, 27) and the second (23, 28) branch comprise each at least one current mirror arrangement (21, 23) and each at least one power inverter stage (27, 28).

2. A differential amplifier as claimed in claim 1,
**characterized by**:
- a third amplifier transistor (41) whose base terminal is coupled to the base terminal of a first amplifier transistor (1),
- a fourth amplifier transistor (42) whose base terminal is coupled to the base terminal of the second amplifier transistor (2),
- at least a second emitter impedance (43, 44) via which the emitter terminals of the third (41) and the fourth (42) amplifier transistor are coupled to each other, and in that
- output currents of the differential amplifier can be derived from collector terminals of the third (41) and the fourth (42) amplifier transistor.

3. A differential amplifier as claimed in claim 1,
**characterized in that**
each one of the current mirror arrangements (21, 23) of the first (21, 27) and the second (23, 28) branch of the power transfer circuit (21, 23, 27, 28) is arranged for deriving one of the output currents of the differential amplifier.

4. A differential amplifier as claimed in claim 1,
**characterized in that**
output currents of the differential amplifier are tapped from collector terminals of the emitter-follower transistors (11, 12).

## Revendications

1. Amplificateur différentiel, comprenant au moins
- un premier transistor amplificateur (1) dont la borne de base est couplée avec une borne d'émetteur d'un premier transistor émetteur-suiveur (11),
- un deuxième transistor amplificateur (2) dont la borne de base est couplée avec une borne d'émetteur d'un deuxième transistor émetteur-suiveur (12),
- une première impédance d'émetteur (3, 4) par l'intermédiaire de laquelle les bornes d'émetteur du premier (1) et du deuxième (2) transistor amplificateur sont couplées ensemble,
dans lequel une tension différentielle (UD) peut être amenée à des bornes de base des transistors émetteurs-suiveurs (11, 12) pour commander l'amplificateur différentiel, avec un circuit de transfert de courant (21, 23, 27, 28) par lequel un premier courant est amené sous découplage de tension à la borne d'émetteur du premier transistor émetteur-suiveur (11), ledit courant se trouvant dans une relation par rapport à un courant de collecteur dans une borne de collecteur du deuxième transistor amplificateur (2), prédéterminée par la configuration du premier transistor émetteur-suiveur (11) et du deuxième transistor amplificateur (2) de telle sorte qu'une tension base-émetteur apparaissant au niveau du premier transistor émetteur-suiveur (11) coïncide au moins approximativement avec une tension base-émetteur apparaissant au niveau du deuxième transistor amplificateur (2), et par lequel un deuxième courant est amené sous découplage de tension à la borne d'émetteur du deuxième transistor émetteur-suiveur (12), ledit courant se trouvant dans une relation par rapport à un courant de collecteur dans une borne de collecteur du premier transistor amplificateur (1), prédéterminée par la configuration du deuxième transistor émetteur-suiveur (12) et du premier transistor amplificateur (1) de telle sorte qu'une tension base-émetteur apparaissant au niveau du deuxième transistor émetteur-suiveur (12) coïncide au moins approximativement avec une tension base-émetteur apparaissant au niveau du premier transistor amplificateur (1),
**caractérisé en ce**
**que** le circuit de transfert de courant (21, 23, 27, 28) comprend une première branche (21, 27) pour dériver le premier courant à partir du courant de collecteur du premier transistor amplificateur (1) et une deuxième branche (23, 28) pour dériver le deuxième courant à partir du courant de collecteur du deuxième transistor amplificateur (2), et en ce que la première branche (21, 27) et la deuxième branche (23, 28) comprennent respectivement au moins un ensemble de miroir de courant (21, 23) et respectivement au moins un étage d'inversion de courant (27, 28).

2. Amplificateur différentiel selon la revendication 1,
**caractérisé par**
- un troisième transistor amplificateur (41) dont la borne de base est couplée avec la borne de base du premier transistor amplificateur (1),
- un quatrième transistor amplificateur (42) dont la borne de base est couplée avec la borne de base du deuxième transistor amplificateur (2),
- au moins une deuxième impédance d'émetteur (43, 44), par l'intermédiaire de laquelle des bornes d'émetteur du troisième (41) et du quatrième (42) transistor amplificateur sont couplées ensemble, et en ce que
- des courants de sortie de l'amplificateur différentiel peuvent être dérivés à partir des bornes de collecteur du troisième (41) et du quatrième (42) transistor amplificateur.

3. Amplificateur différentiel selon la revendication 1,
**caractérisé en ce**
**que** respectivement l'un des ensembles de miroir de courant (21, 23) de la première branche (21, 27) et de la deuxième branche (23, 28) du circuit de transfert de courant (21, 23, 27, 28) est réalisé pour dériver respectivement l'un des courants de sortie de l'amplificateur différentiel.

4. Amplificateur différentiel selon la revendication 1,
**caractérisé en ce**
**que** les courants de sortie de l'amplificateur différentiel sont dérivés à partir de bornes de collecteur des transistors émetteurs-suiveurs (11, 12).
